Europäisches Patentamt

European Patent Office

Office européen des brevets

(19)

(11) Publication number: **0 183 474 B1**

# EUROPEAN PATENT SPECIFICATION

(12)

(45) Date of publication of patent specification: **24.04.91** (51) Int. Cl.⁵: **H01L 29/80**

(21) Application number: **85308422.6**

(22) Date of filing: **19.11.85**

(54) Semiconductor device.

(30) Priority: **19.11.84 JP 242413/84**

(43) Date of publication of application:
**04.06.86 Bulletin 86/23**

(45) Publication of the grant of the patent:
**24.04.91 Bulletin 91/17**

(84) Designated Contracting States:
**DE FR GB**

(56) References cited:
**EP-A- 0 077 706**
**WO-A-81/00489**
**FR-A- 2 504 732**
**US-A- 4 353 081**

**INTERNATIONAL ELECTRON DEVICES MEET-**
**ING, TECHNICAL DIGEST, San Francisco, CA,**
**13th-15th December 1982, pages 594-597,**
**IEEE, New York, US; U. MISHRA et al.:**
**"Submicron GaAs vertical electron transis-**
**tor"**

**APPLIED PHYSICS LETTERS, vol. 45, no. 3,**
**August 1984, pages 258-260, American In-**
**stitute of Physics, New York, US; Z. RAV-NOY**
**et al.: "Vertical field-effect transistors in III-V**
**semiconductors"**

**PATENT ABSTRACTS OF JAPAN, vol. 10, no.**
**121 (E-401)[2178], 7th May 1986; & JP-A-60**
**254 778**

(73) Proprietor: **FUJITSU LIMITED**
**1015, Kamikodanaka Nakahara-ku**
**Kawasaki-shi Kanagawa 211(JP)**

(72) Inventor: **Yokoyama, Naoki**
**326, Rivahaitsu 2557-1, Tsumada**
**Atsugi-shi Kanagawa 243(JP)**

(74) Representative: **Fane, Christopher Robin King**
**et al**
**HASELTINE LAKE & CO. Hazlitt House 28**
**Southampton Buildings Chancery Lane**
**London, WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a semiconductor device.

A device described as a permeable base transistor (PBT) and comprising an emitter layer, a comb-shaped or lattice-shaped base electrode, a base layer, a collector layer, an emitter electrode, and a collector electrode has been proposed in WO-A-8I/00489.

In such a PBT, the value of the voltage applied to a comb-shaped base electrode can be used to change the coverage of the depletion layer extending from the base electrode in the horizontal direction. This effect can be used to control the electrons passing between the comb-shaped base electrode from the emitter layer to the collector layer.

The thickness of the base electrode is about 0.02 $\mu$m, corresponding to a field effect transistor (FET) which also has a short gate length of about 0.02 $\mu$m. Therefore, the time taken for electrons to pass through the base electrode in the PBT is very short, enabling a high speed of operation.

However, the switching speed of such a PBT is about 15 ps at best. Thus, a higher switching speed PBT is required.

According to one aspect of the present invention there is provided a semiconductor device wherein a base layer is sandwiched between an emitter layer and a collector layer, and an electrode layer having an array of gaps therein is provided at a heterojunction between the emitter layer and the base layer, characterised in that the said emitter layer has an energy band gap which is greater in width than that of the said base layer.

Reference will now be made, by way of example, to the accompanying drawings, in which:-
Fig. 1 shows a cross-sectional view of a previously-proposed PBT;
Fig. 2 shows a cross-sectional view of a PBT embodying the present invention;
Figs. 3 and 5 show respective partial cross-sectional views of the embodiment of Fig. 2;
Figs. 4 and 6 are energy band diagrams for Figs. 3 and 5, respectively;
Fig. 7 is an energy band diagram;
Fig. 8 is a circuit diagram using a PBT embodying the present invention;
Figs. 9A to 9D show cross-sectional views explaining the process of producing a structure according to an embodiment of the present invention;
Fig. 10 shows a cross-sectional view of an IC device according to an embodiment of the present invention;
Fig. 11A shows a plan view of a comb-shaped base electrode 2; and
Fig. 11B shows a plan view of a lattice-shaped electrode 2.

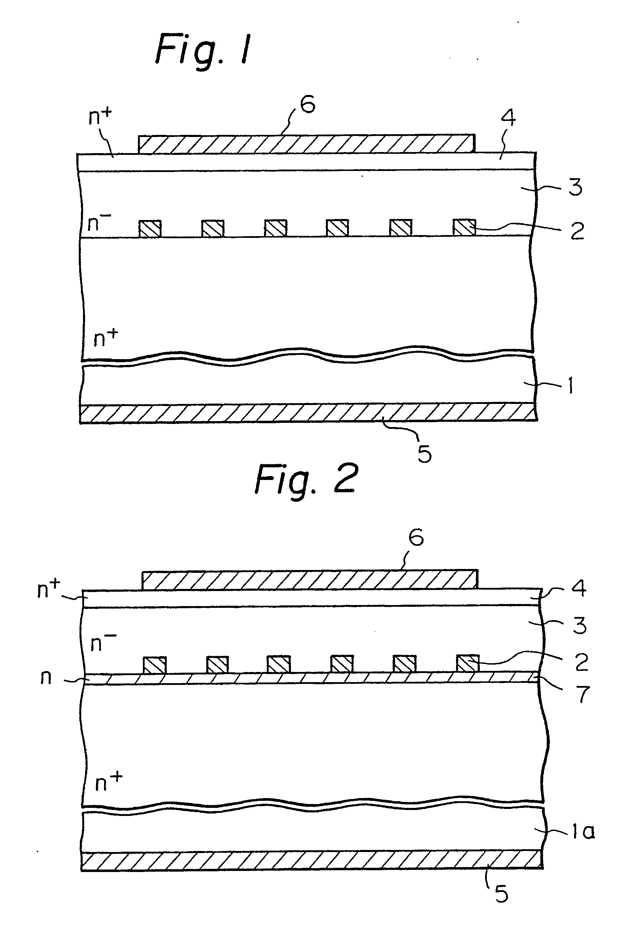

Figure 1 shows a cross-sectional view of a PBT proposed previously.

As shown in Fig. 1, on a $n^+$ type GaAs emitter layer 1, a comb-shaped or lattice-shaped base electrode 2 composed of a high melting point metal such as tungsten (W) or a metal silicide such as tungsten silicide (WSi) is formed. Over the entire surface of the base electrode 2 and the emitter layer 1, an $n^-$ type GaAs base layer 3 is formed. On the base layer 3, an $n^+$ type GaAs collector layer 4 is formed. Reference numerals 5 and 6 denote an emitter electrode and collector electrode, respectively.

In the above-mentioned structure of a PBT, as explained above, the passing time of electrons from the emitter layer 1 to the collector layer 4 through the base electrode 2 is such that the switching speed limit is about 15 ps.

Figure 2 is a cross-sectional view of a PBT embodying the present invention.

As shown in Fig. 2, an n type AlGaAs emitter layer 7 is additionally formed on the $n^+$ type GaAs emitter layer, which is denoted as 1a in Fig. 2. Other structures, for example the base electrode 2, are the same as in Fig. 1.

The n type AlGaAs emitter layer 7 has a wider energy bandgap than the $n^-$ type GaAs base layer 3 and $n^+$ type GaAs collector layer 4. Further, the comb-shaped or lattice-shaped base electrode 2 is formed on a heterojunction surface formed by the n type AlGaAs emitter layer 7 and the $n^-$ type GaAs base layer 3. A Schottky junction or insulation layer 10 is interposed at respective interfaces between the electrode 2 and the emitter and base layers (7, 3). Thus the base electrode 2 is not in ohmic contact with the base layer 3 or the emitter layer 7.

The operation of the PBT described above will now be explained.

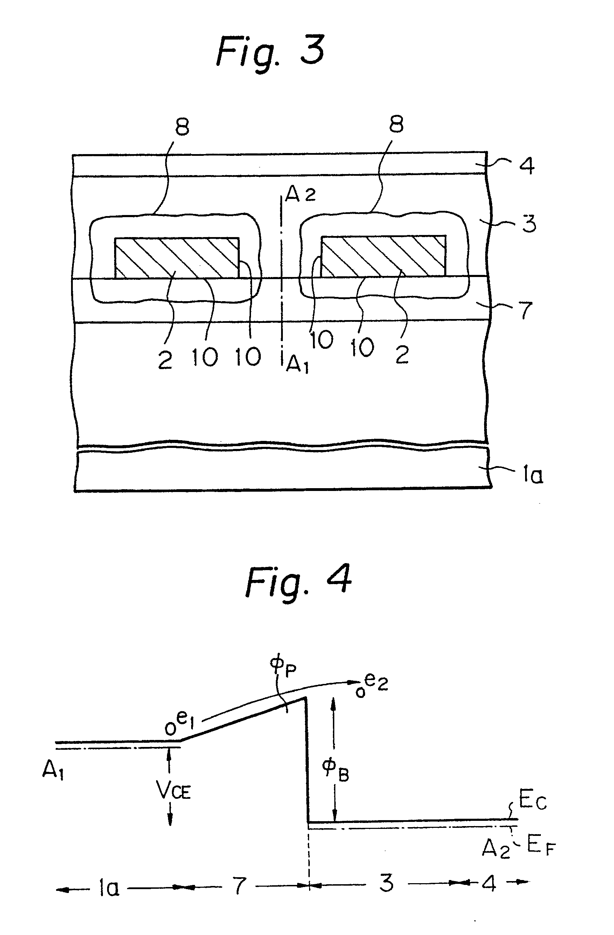

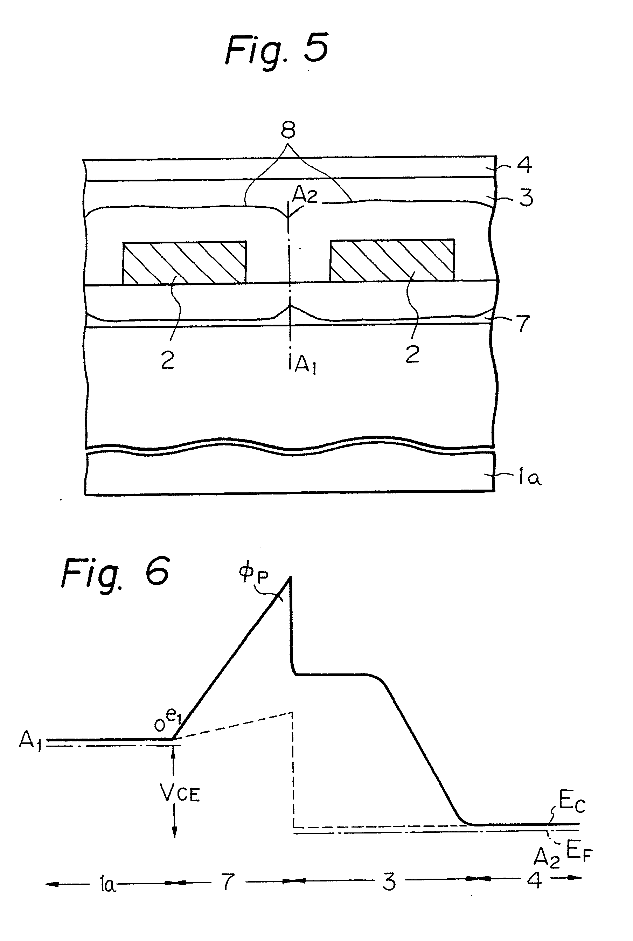

Figures 3 and 5 show partial cross-sectional views of the embodiment, explaining depletion layers when $V_{BE} > 0$ and $V_{CE} > 0$, and when $V_{BE} = 0$ and $V_{CE} > 0$, respectively.

Figures 4 and 6 are energy band diagrams for Figs. 3 and 5, respectively.

In Figs. 3 to 6, the areas 8 around the comb-shaped or lattice-shaped base electrode 2 denote depletion layers, and $e_1$ (o) and $e_2$ (o) denote electrons and hot electrons, respectively.

In Fig. 3, $V_{CE}$ (a voltage between the collector layer 4 and the emitter contact layer 1a) $> 0$, and $V_{BE}$ (a voltage between the base electrode 2 and the emitter layer) $> 0$, so the PBT is in an ON state. That is, not all the base layer 3 in the gaps of the base electrode 2 is converted to a depletion layer, so the potential barrier $\phi_p$ is low as shown in Fig. 4. Consequently, electrons $e_1$ in an emitter contact layer 1a are injected into the base layer 3 through the emitter layer 7. When the electrons $e_1$ are injected into the base layer 3, since there is an energy barrier $\phi_B$ according to the wider band gap emitter layer 7, the injected electrons $e_1$ obtain a high kinetic energy so that the electrons $e_2$ become hot electrons which have a high initial speed. Therefore, such hot electrons $e_2$ can pass the base layer 3 with the high speed so as to reach the collector layer 4, whereby a collector current flows. In the case of Fig. 3, the voltage between the base and emitter ($V_{BE}$) is, for example, 0.3 V, and the voltage between the collector and emitter ($V_{CE}$) is, for example, 0.6 V.

On the other hand, in Fig. 5, $V_{CE} > O$ and $V_{BE} = O$, so the PBT is in an OFF state. That is, all of the base layer 3 in the gaps of the base electrode 2 is converted to a depletion layer because of the built-in potential between the base electrode 2 and the base layer 3, so that the potential barrier $\phi_p$ is high, as shown in Fig. 6. Consequently, the electrons $e_1$ in the emitter contact layer 1a are not injected into the base layer 3, so that no collector current flows. In the case of Fig. 5, $V_{CE}$ is given as 0.2 V. In Fig. 6, the broken line illustrates the conduction band in Fig. 4. Therefore, the PBT turns ON or OFF depending upon whether $V_{BE} > O$ or $V_{BE} = O$.

As shown in Figs. 4 and 6, the barrier height of the emitter layer 7 gradually increases from the emitter contact layer 1a to the base layer 3, so as to enable the electrons $e_1$ in the emitter contact layer 1a to inject into the base layer 3 through the wide band gap layer 7.

The electrons $e_1$ injected from the emitter layer 7 into the base layer 3 in Fig. 3 lose potential energy therebetween. The electrons $e_1$ gain kinetic energy in place of the loss of the potential energy so that the electrons $e_1$ change to hot electrons $e_2$. Thus, the speed of the electrons $e_2$ in the base layer 3 is increased, for example to $1 \times 10^8$ cm/sec., to provide a significantly higher switching speed as compared with the PBT of Fig. 1.

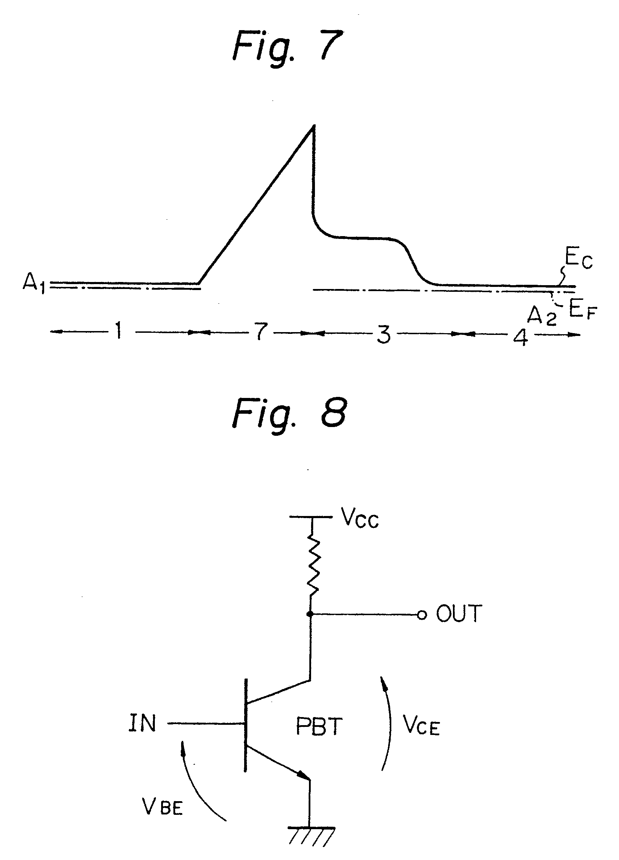

Figure 7 shows an energy band diagram when $V_{CE} = O$ and $V_{BE} = O$, i.e. in the normally off state.

Figure 8 schematically shows an example of a circuit diagram using a PBT embodying the present invention. This is an inverter circuit.

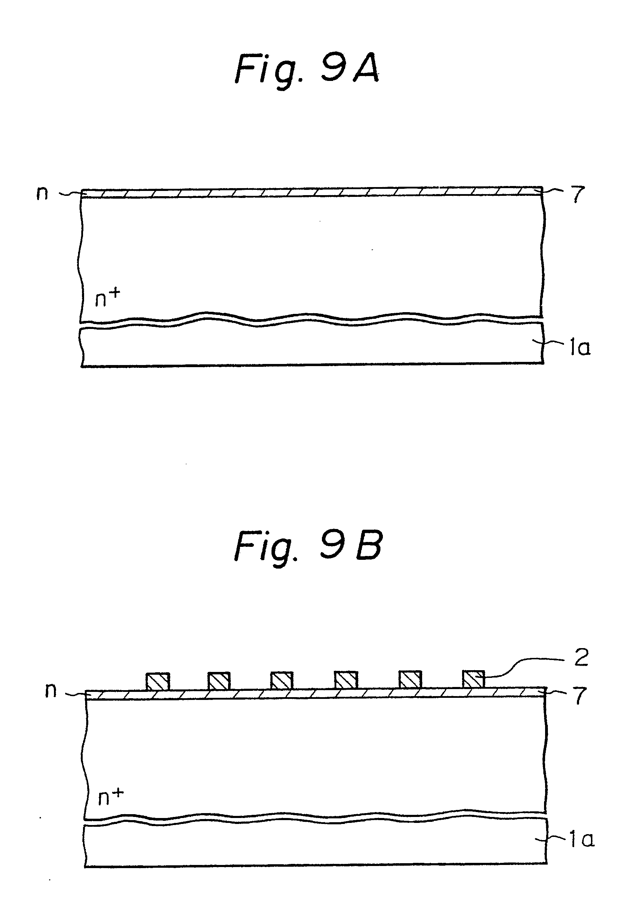

Figures 9A to 9D are cross-sectional views explaining the process of producing a structure according to an embodiment of the present invention.

As shown in Fig. 9A, on an $n^+$ type GaAs emitter contact layer 1a, an n type $Al_xGa_{1-x}As$ emitter layer 7 having a thickness of about 1000 Å (0.1μm) is formed by molecular beam epitaxy (MBE). The x value of the emitter layer 7 is steadily increased from O as the layer is built up, so that at the 1000 Å thickness the x value is 0.3. Accordingly an energy barrier $\phi_B$ will exist between the emitter layer 7 and the base layer 3. Furthermore, the graded x value of the emitter layer 7 generates a graded energy level between the emitter contact layer 1a and the base layer 3. To form the emitter layer 7, a chemical vapor deposition (CVD) process may alternatively be used.

As shown in Fig. 9B, a tungsten layer having a thickness of about 200 Å (0.02 μm) is formed on the n type $Al_xGa_{1-x}As$ emitter layer 7. The tungsten layer is patterned with an array of gaps, by a conventional photolithography technique, to form a comb-shaped base electrode 2.

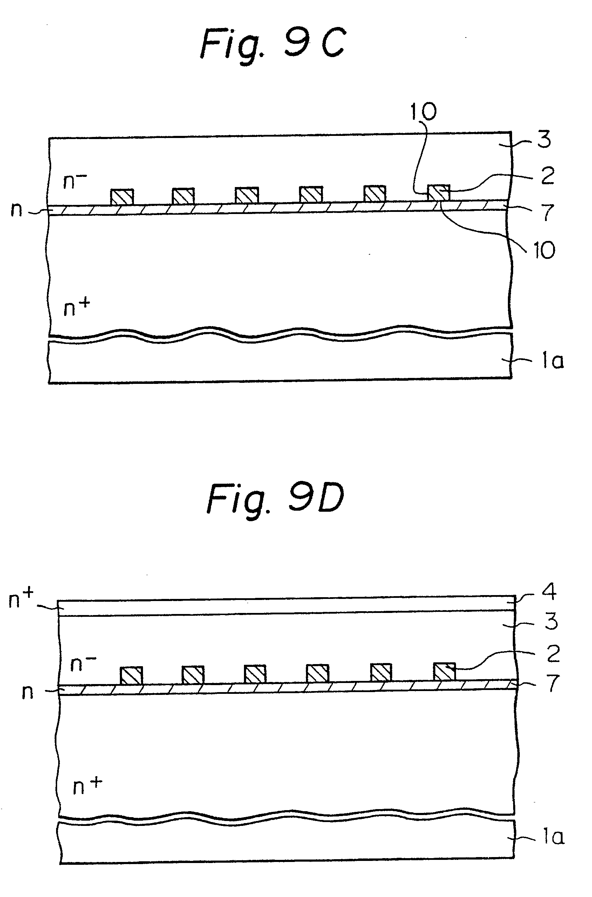

As shown in Fig. 9C, on the obtained structure, an $n^-$ type GaAs base layer 3 having a thickness of about 4000 Å (0.4 μm) with a carrier concentration of $5 \times 10^{16}$ cm$^{-3}$ is formed by the MBE process. In place of the MBE process, a vapor phase epitaxy (VPE) process may be used.

As shown in Fig. 9D, an $n^+$ type GaAs collector layer 4 having a thickness of about 2000 Å (0.2 μm) is formed on the $n^-$ type GaAs base layer 3 by using MBE or VPE continuously.

Finally, as shown in Fig. 2, respective AuGe/An layers each having a thickness of about 4000 Å (0.4 μm) are formed on the collector layer 4 and the emitter contact layer 1a to form a collector electrode 6 and an emitter electrode 5 respectively.

It should be noted that the base electrode 2 connects to the emitter layer 7 and the base layer 3 through a Schottky junction or insulating layer 10.

In an embodiment of the present invention, in place of the GaAs, $In_yGa_{1-x}As$ may be used. In place of the $Al_xGa_{1-x}As$, InP and $Al_zIn_{1-z}As$ may be used.

Further, in an embodiment of the present invention the order of the position of the emitter layer, the base layer, and the collector layer may be reversed.

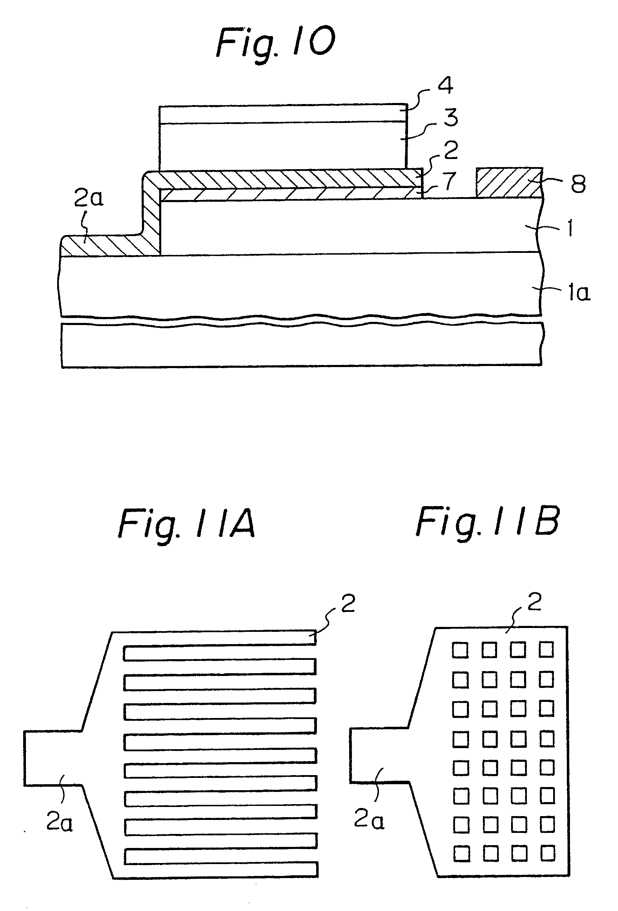

In the above-mentioned embodiment, a single semiconductor device was explained. However, the single semiconductor device can be easily changed to an IC device. For example, as shown in Fig. 10, on a semi-insulating GaAs substrate 1a each semiconductor layer such as an $n^+$ type GaAs emitter layer 1 is formed. After that by a selective mesa etching process a part of the surface of the $n^+$ type GaAs emitter layer 1 is exposed whereby an emitter electrode 5 may be taken out therefrom.

Figure 11A is a plan view of a comb-shaped base electrode 2.

In Fig. 11A reference numeral 2a denotes a contact portion.

Figure 11B is a plan view of a lattice-shaped base electrode 2.

## Claims

**1.** A semiconductor device wherein a base layer (3) is sandwiched between an emitter layer (7) and a collector layer (4), and an electrode layer (2) having an array of gaps therein is provided at a heterojunction between the emitter layer (7) and the base layer (3), characterised in that the said emitter layer (7) has an energy band gap which is greater in width than that of the said base layer (3).

**2.** A device as claimed in claim 1, wherein the said emitter layer (7) is sandwiched between the base layer (3) and an emitter contact layer (1a) such that electrons passing through the emitter layer (7) in the direction from the emitter contact layer (1a) to the base layer (3) encounter an opposing potential barrier which increases with distance, in the said direction, through the said emitter layer (7).

**3.** A device as claimed in claim 1 or 2, wherein the said electrode layer (2) is surrounded by either a Schottky junction (10) or an insulating layer such that the layer (2) is not in ohmic contact with the emitter layer (7) or the base layer (3).

## Revendications

**1.** Dispositif à semiconducteur dans lequel une couche de base (3) est prise en sandwich entre une couche d'émetteur (7) et une couche de collecteur (4), et une couche d'électrode (2) comportant un ensemble d'intervalles est disposée en une hétérojonction formée entre la couche d'émetteur (7) et la couche de base (3), caractérisé en ce que ladite couche d'émetteur (7) possède une bande interdite d'énergie qui est plus grande, en largeur, que celle de ladite couche de base (3).

**2.** Dispositif selon la revendication 1, dans lequel ladite couche d'émetteur (7) est prise en sandwich entre la couche de base (3) et une couche de contact d'émetteur (1a), si bien que des électrons ayant traversé la couche d'émetteur (7) suivant la direction qui va de la couche de contact d'émetteur (1a) à la couche de base (3) rencontrent une barrière de potentiel leur faisant opposition, qui augmente avec la distance, suivant ladite direction, dans ladite couche d'émetteur (7).

**3.** Dispositif selon la revendication 1 ou 2, dans lequel ladite couche d'électrode (2) est entourée par une jonction de Schottky (10) ou une couche isolante, si bien que la couche (2) n'est pas en contact ohmique avec la couche d'émetteur (7) ou la couche de base (3).

## Ansprüche

**1.** Halbleitervorrichtung, bei der eine Basisschicht (3) sandwichartig zwischen einer Emitterschicht (7) und einer Kollektorschicht (4) angeordnet ist, und eine Elektrodenschicht (2), die ein Array von Spalten darin hat, an einem Heteroübergang zwischen der Emitterschicht (7) und der Basisschicht (3) vorgesehen ist, dadurch gekennzeichnet, daß die genannte Emitterschicht (7) eine Energiebandlücke hat, die in der Breite größer als jene der genannten Basisschicht (3) ist.

**2.** Vorrichtung nach Anspruch 1, bei der die genannte Emitterschicht (7) sandwichartig zwischen der Basisschicht (3) und einer Emitterkontaktschicht (1a) so angeordnet ist, daß Elektronen, die durch die Emitterschicht (7) in Richtung von der Emitterkontaktschicht (1a) zu der Basisschicht (3) hindurchtreten, auf eine entgegengesetzte Potentialbarriere treffen, welche mit der Distanz, in der genannten Richtung, durch die genannte Emitterschicht (7) wächst.

**3.** Vorrichtung nach Anspruch 1 oder 2, bei der die genannte Elektrodenschicht (2) entweder von einer Schottky-Grenzschicht (10) oder von einer isolierenden Schicht umgeben ist, so daß die Schicht (2) mit der Emitterschicht (7) oder der Basisschicht (3) nicht in ohmschem Kontakt ist.

## Fig. 1

## Fig. 2

## Fig. 3

## Fig. 4

EP 0 183 474 B1

Fig. 5

Fig. 6

7

## Fig. 7

## Fig. 8

# Fig. 9A

n — ///////////////////////////////////////// — 7

$n^+$

— 1a

# Fig. 9B

2

n — ▨ ▨ ▨ ▨ ▨ ▨ — 7

$n^+$

— 1a

## Fig. 9 C

## Fig. 9 D

## Fig. 10

## Fig. 11A    Fig. 11B